# EUROPÄISCHE PATENTSCHRIFT

(11) **EP 2 514 287 B1**
(45) Veröffentlichungstag und Bekanntmachung des Hinweises auf die Patenterteilung: **15.08.2018**
(21) Anmeldenummer: 10810758.2
(22) Anmeldetag: 17.12.2010
(51) Int. Cl.: H05K 5/00, H05K 7/14, H02B 1/04

(54) **MODULEINHEIT**
MODULE UNIT
UNITÉ MODULAIRE

(30) Priorität: 17.12.2009 DE 102009059010
(43) Veröffentlichungstag der Anmeldung: 24.10.2012
(73) Patentinhaber: Phoenix Contact GmbH & Co. KG, 32825 Blomberg (DE)
(72) Erfinder: SÖFKER, Jörg, 32657 Lemgo (DE)
(74) Vertreter: Muth, Bruno
(86) Internationale Anmeldenummer: PCT/EP2010/007723
(87) Internationale Veröffentlichungsnummer: WO 2011/082799

(56) Entgegenhaltungen:
- EP-A2- 0 241 074
- EP-A2- 1 137 334
- WO-A1-2008/009491
- DE-A1- 19 924 344
- DE-B3-102005 043 055
- DE-U1- 20 004 263
- DE-U1-202004 012 462
- US-A- 4 261 940
- US-A- 4 547 236

## Beschreibung

Die Erfindung betrifft eine Moduleinheit mit einem wannenförmigen Aufnahmeelement zur Aufnahme einer oder mehrerer Leiterplatten, wobei das Aufnahmeelement eine Bodenplatte und zwei an der Bodenplatte angeordnete Halterungselemente aufweist, wobei die Halterungselemente jeweils mehrere Einschubbereiche aufweisen, in welche die ein oder mehreren Leiterplatten zur Befestigung an dem Aufnahmeelement eingeschoben werden, und mit zwei an dem Aufnahmeelement anordbaren Seitenelementen zum Verhindern eines seitlichen Herausrutschens der ein oder mehreren Leiterplatten aus den Halterungselementen an den beiden offenen Seitenbereichen des Aufnahmeelementes, wobei das Aufnahmeelement aus einem Extrusionsprofil gebildet ist, wobei das Aufnahmeelement mindestens zwei Ausnehmungen aufweist, innerhalb welcher die Seitenelemente an dem Aufnahmeelement durch Einrasten befestigbar sind, wobei die Moduleinheit auf einer Tragschiene oder mittels eines Befestigungsflansches unmittelbar auf einer Montageplatte befestigt werden kann. Ferner betrifft die Erfindung ein Verfahren zur Herstellung einer entsprechenden Moduleinheit.

Eine derartige Moduleinheit weist meist ein Aufnahmeelement in Form eines wannenförmigen Trägerelements auf, innerhalb welchem je nach Bedarf ein oder mehrere Leiterplatten in an dem Aufnahmeelement vorgesehenen Halterungselementen eingeschoben werden können. Die Leiterplatten werden dabei meist an zwei in Richtung der Längsachse der Leiterplatten verlaufenden Seitenbereichen der Leiterplatten von den Halterungselementen in nutförmigen Bereichen U-förmig umgeben. Um ein Herausrutschen der Leiterplatten aus den Halterungselementen und damit aus dem Aufnahmeelement zu verhindern, werden an den beiden offenen Seitenbereichen des Aufnahmeelements, über welche die Leiterplatten in das Aufnahmeelement eingeschoben werden können, jeweils ein Seitenelement an dem Aufnahmeelement mittels Schrauben angeschraubt.

Nachteilig hierbei ist, dass dadurch, dass zur Herstellung der Moduleinheit die Seitenelemente an das Aufnahmeelement angeschraubt werden müssen, sowohl ein zusätzlicher Fertigungsschritt als auch zusätzliche Befestigungselemente in Form von Schrauben notwendig sind, so dass die Montage der Moduleinheit aufwendig und zeitintensiv ist.

Aus der DE 199 24 344 A1 ist ein als Moduleinheit ausgebildetes Gehäuse für elektrische Bauteile bekannt. Das Gehäuse weist ein Aufnahmeelement zur Aufnahme einer Leiterplatte und zwei an dem Aufnahmeelement anordbare Seitenelemente auf. Das Aufnahmeelement ist aus einem Extrusionsprofil gebildet und weist mindestens zwei Ausnehmungen auf, innerhalb welcher die Seitenelemente an dem Aufnahmeelement durch Einrasten befestigbar sind.

Die DE 200 04 263 U1 offenbart eine Moduleinheit mit einem Aufnahmeelement, wobei das Aufnahmeelement eine Bodenplatte und zwei an der Bodenplatte angeordnete Halterungselemente aufweist. An dem Aufnahmeelement werden zwei Seitenelemente befestigt, wobei die Befestigung der Seitenelemente an den Halterungselementen erfolgt, indem die Seitenelemente mit den Halterungselementen verschraubt werden, wozu entsprechende Ausnehmungen in den Halterungselementen vorgesehen sind.

Aus der DE 0 241 074 A2 ist eine Pendelleuchte für langgestreckte Entladungslampen mit einem Aufnahmeelement bekannt, welches ein Bodenelement und zwei davon abstehende Halterungselemente aufweist. Stirnseitig von dem Aufnahmeelement werden Seitenelemente an dem Aufnahmeelement befestigt, wobei diese an einem in das Aufnahmeelement eingesetzten rahmenartigen Einsatz befestigt werden.

Der Erfindung liegt die Aufgabe zu Grunde, eine Lösung zu schaffen, welche sich durch eine vereinfachte und schnellere Montage einer Moduleinheit auszeichnet.

Die Lösung der Aufgabe erfolgt erfindungsgemäß durch die Merkmale der unabhängigen Ansprüche. Vorteilhafte Ausgestaltungen der Erfindung sind in den Unteransprüchen angegeben.

Bei einer Moduleinheit der eingangs näher bezeichneten Art wird diese Aufgabe dadurch gelöst , dass an einer Unterseite der Bodenplatte des Aufnahmeelementes ein Stegelement ausgebildet ist, welches sich mit seiner Längsachse entlang einer Einschubrichtung der Leiterplatten erstreckt, wobei die mindestens zwei Ausnehmungen des Aufnahmeelements an dem Stegelement ausgebildet sind, wobei sich die Ausnehmungen quer zur Längsachse des Stegelements erstrecken.

Bei einem Verfahren der eingangs näher bezeichneten Art wird diese Aufgabe dadurch gelöst, dass Aufnahmeelemente von einem Extrusionsprofil abgelängt werden, wobei gleichzeitig beim Ablängen Ausnehmungen in die Aufnahmeelemente eingebracht werden.

Dadurch, dass das Aufnahmeelement aus einem Extrusionsprofil gebildet ist, kann das Aufnahmeelement je nach Bedarf in beliebigen Längen ausgebildet sein. Je nach der von dem Anwender gewünschten Modullänge und dem benötigten bzw. zur Verfügung gestellten Platzangebot für die Moduleinheit kann das als Extrusionsprofil ausgebildete Aufnahmeelement individuell abgelängt werde. Dadurch ist beispielsweise eine optimale Anpassung der Moduleinheit an die Abmessungen der von dem Aufnahmeelement aufgenommenen Leiterplatten möglich, wodurch eine Vielzahl von Elektronikschaltungen schienenmontabel realisierbar ist. Das Aufnahmeelement kann dabei sowohl aus einem Kunststoff als auch aus einem Metall, vorzugsweise Aluminium, hergestellt sein. Weist das Aufnahmeelement eine relative kurze Länge auf, so ist das Aufnahmeelement vorzugsweise aus einem kostengünstigeren Kunststoff, beispielsweise Polyvinylchlorid, und/oder aus einem temperaturstabileren Kunststoff, beispielsweise Polyamid, hergestellt. Bei größeren Längen des Aufnahmeelements ist das Aufnahmeelement vorzugsweise aus einem Metall hergestellt, da ein aus einem Metall hergestelltes Aufnahmeelement eine größere Formstabilität aufweist.

Die Befestigung der Seitenelemente an dem Aufnahmeelement erfolgt erfindungsgemäß nicht mehr mittels Schrauben, wie dies aus dem Stand der Technik bekannt ist, sondern mittels an dem als Extrusionsprofil ausgebildeten Aufnahmeelement vorgesehenen Ausnehmungen, in welche die Seitenelemente schnell und einfach eingerastet werden können. Die Montage, bei welcher die Seitenelemente auf das Aufnahmeelement aufgeschoben werden, und die abschließende Befestigung der Seitenelemente an dem Aufnahmeelement können somit nunmehr in einem Fertigungsschritt erfolgen. Zusätzliche Befestigungselemente, wie beispielsweise Schrauben, sind aufgrund der Befestigung durch Einrasten nicht mehr notwendig, so dass sowohl der Montageaufwand als auch die Montagezeit einer derartigen Moduleinheit gegenüber bekannten Moduleinheiten wesentlich reduziert werden kann.

Die Ausnehmungen werden dabei vorzugsweise in das Extrusionsprofil mittels mechanischer Bearbeitung, beispielsweise mittels Sägen, Bohren und/oder Fräsen, eingebracht, nachdem das Extrusionsprofil durch Extrudieren fertig ausgeformt worden ist. Die Ausnehmungen können dabei beliebig entlang der Umfangsfläche des Aufnahmeelements vorgesehen sein. Vorteilhafterweise werden die Ausnehmungen in einem Fertigungsschritt gleichzeitig beim Ablängen des Aufnahmeelements auf die gewünschte Länge in das Aufnahmeelement eingebracht, wodurch die Fertigungskosten reduziert werden können. Dafür kann beispielsweise eine Sägevorrichtung, insbesondere eine Kreissägevorrichtung, verwendet werden, welche derart modifiziert ist, dass sie mit zwei zusätzlichen Sägeblättern beim Ablängen des Aufnahmeelements gleichzeitig jeweils eine Ausnehmung für ein Ende des abzulängenden Aufnahmeelements und für einen Anfang des nächsten Aufnahmeelements erzeugen kann, indem neben einem Hauptsägeblatt, welches zum Ablängen des Aufnahmeelements dient, jeweils ein zusätzliches Sägeblatt rechts und links von dem Hauptsägeblatt an der Säge angeordnet ist, wobei das Hauptsägeblatt derart eingestellt ist, dass es eine größere Einschnitttiefe aufweist als die beiden zusätzlichen Sägeblätter rechts und links von dem Hauptsägeblatt. Nach einer bevorzugten Ausgestaltung der Erfindung ist es daher vorgesehen, dass zum Ablängen und zum Einbringen der Ausnehmungen eine Sägevorrichtung verwendet wird, wobei über ein Hauptsägeblatt der Sägevorrichtung Aufnahmeelemente von dem Extrusionsprofil abgelängt werden und über zwei zusätzliche an der Sägevorrichtung vorgesehene Sägeblätter jeweils eine Ausnehmung an einem Ende des abzulängenden Aufnahmeelementes und an einem Anfang eines nächsten abzulängenden Aufnahmeelementes eingebracht werden. Die Ausnehmungen werden dabei vorzugsweise quer zur Aufschiebrichtung der Seitenelemente auf das Aufnahmeelement in das Aufnahmeelements in Form von vorzugsweise länglichen, nutförmigen Ausnehmungen eingebracht. Das Aufnahmeelement weist dabei vorzugsweise zwei sich gegenüberliegende Endabschnitte zur Befestigung der beiden Seitenelemente auf, wobei im Bereich dieser beiden Endabschnitte jeweils ein oder mehrere der Ausnehmungen eingebracht werden. An diese beiden mit Ausnehmungen versehenen Endabschnitte können nach dem Einbringen der Ausnehmungen in das Extrusionsprofil und nach der Aufnahme einer oder mehrerer Leiterplatten jeweils ein Seitenelement an die beiden Endabschnitte angefügt werden, indem die Seitenelemente auf die Endabschnitte aufgeschoben werden und innerhalb der Ausnehmungen auf einfache Art und Weise verrasten können, ohne dass hierfür zusätzliche Hilfsmittel notwendig wären.

Nach einer bevorzugten Ausgestaltung der Erfindung weisen die Seitenelemente Rastmittel zum Befestigen der Seitenelemente innerhalb der Ausnehmungen des Aufnahmeelements auf. Die Rastmittel sind vorzugsweise federnd ausgebildet. Ein Rastmittel weist dabei vorzugsweise einen länglichen Federarm auf, welcher elastisch ausgebildet ist. An einem freien Ende des Federarms ist vorzugsweise ein Rasthaken ausgebildet, welcher in eine Ausnehmung an dem Aufnahmeelement eingreifen kann. Der längliche Federarm ermöglicht eine Bewegung des Rasthakens, so dass dieser beim Aufschieben des Rastmittels auf das Aufnahmeelement in die Ausnehmung einhaken kann und bei Bedarf mittels eines Werkzeuges wieder aus der Ausnehmung ausgehakt werden kann. Durch das Vorsehen eines Rastmittels an den Seitenelementen können die Seitenelemente formschlüssig in die Ausnehmungen an dem Aufnahmeelement einrasten, um die Seitenelemente auf einfache Art und Weise, insbesondere durch die federnde Ausgestaltung des Rastmittels, lösbar mit dem Aufnahmeelement verbinden zu können.

Weiter ist es bevorzugt vorgesehen, dass die Seitenelemente jeweils mittels eines an den Seitenelementen vorgesehenen Führungselementes auf das Stegelement aufschiebbar sind. Das Stegelement ist vorzugsweise an einer Bodenplatte des Aufnahmeelements angeformt. Vorzugsweise weist das Aufnahmeelement mehr als ein Stegelement und die Seitenelemente weisen jeweils mehr als ein Führungselement auf. Dadurch, dass die Seitenelemente mittels Führungselemente auf an dem Aufnahmeelement vorgesehenen Stegelementen aufgeschoben werden können, ist eine gezielte Positionierung und Führung der Seitenelemente bei der Montage der Seitenelemente an dem Aufnahmeelement realisierbar. Das Stegelement ist dabei vorzugsweise T-förmig ausgebildet. Das Führungselement ist vorzugsweise derart ausgebildet, dass es die Stegelemente zumindest teilweise umgreifen kann, so dass das Führungselement nicht ungewollt von dem Stegelement abrutschen kann. Das Führungselement ist dabei vorzugsweise U-förmig mit nach innen abgewinkelten Endabschnitten ausgebildet, so dass das Führungselement das vorzugsweise T-förmige ausgebildete Stegelement sicher umgreifen kann.

Die Ausnehmungen des Aufnahmeelements sind dabei nach einer bevorzugten Ausgestaltung der Erfindung im Bereich des Stegelements und die Rastmittel eines Seitenelements im Bereich des Führungselements vorgesehen. Die Ausnehmungen sind demnach vorzugsweise nicht an der Bodenplatte des Aufnahmeelements vorgesehen, da dies eine Schwächung des Aufnahmeelements hervorrufen würde, sondern die Ausnehmungen sind in das an der Bodenplatte des Aufnahmeelements vorgesehene Stegelement eingebracht. Das Stegelement ist mit seiner Längsachse vorzugsweise in Einschiebrichtung der Leiterplatte ausgebildet, wobei die Ausnehmungen vorzugsweise quer zur Längsachse des Stegelements in das Stegelement eingebracht sind. Die zum Einrasten der Seitenelemente an dem Aufnahmeelement vorgesehenen Rastmittel sind vorzugsweise im Bereich des an den Seitenelementen vorgesehenen Führungselements ausgebildet, vorzugsweise innerhalb des U-förmig ausgebildeten Führungselements positioniert, so dass beim Aufschieben des Führungselements auf das Stegelement nach einem bestimmten zurückgelegten Weg das Führungselement mittels des an dem Rastmittel angeordneten Rasthakens in die an dem Stegelement vorgesehene Ausnehmung einrasten kann, wodurch eine sichere Fixierung der Seitenelemente an dem Aufnahmeelement realisierbar ist.

Bevorzugt ist es vorgesehen, dass eine erste Leiterplatte und eine zweite Leiterplatte in dem Aufnahmeelement aufgenommen sind, wobei das Aufnahmeelement zwei Halterungselemente zur Aufnahme der ersten und der zweiten Leiterplatte aufweist. Die zwei Halterungselemente sind dabei vorzugsweise derart geformt, dass die erste Leiterplatte an zwei sich gegenüberliegenden Seitenbereichen der ersten Leiterplatte jeweils von einem der zwei Halterungselemente U-förmig umgeben ist und die zweite Leiterplatte mit zwei sich gegenüberliegenden Seitenbereichen der zweiten Leiterplatte auf den zwei Halterungselementen aufliegt. Die erste Leiterplatte ist dabei vorzugsweise zwischen der Bodenplatte des Aufnahmeelements und der zweiten Leiterplatte vorgesehen, wobei die Bodenplatte, die erste Leiterplatte und die zweite Leiterplatte parallel zueinander angeordnet sind. Die zweite Leiterplatte ist demnach die Leiterplatte, welche am weitesten von der Bodenplatte des Aufnahmeelements innerhalb des Aufnahmeelements angeordnet ist. Es ist auch möglich weitere Leiterplatten zwischen der ersten Leiterplatte und der zweiten Leiterplatte vorzusehen. Die Halterungselemente sind vorzugsweise in Form von länglichen Profilschienen ausgebildet, welche sich in Einschubrichtung der Leiterplatten entlang der Längsachse des Aufnahmeelements erstrecken. Die Halterungselemente sind sich gegenüberliegend an zwei Randbereichen des Aufnahmeelements an der Bodenplatte des Aufnahmeelements angeordnet, wobei sich die Halterungselemente mit ihrer Querschnittsfläche orthogonal zur Bodenplatte des Aufnahmeelements erstrecken. Die Halterungselemente weisen mehrere Abschnitte auf, in welche die verschiedenen Leiterplatten angeordnet werden können. Der Abschnitt eines Halterungselements, in welchem die erste Leiterplatte eingeschoben werden kann, ist vorzugsweise U-förmig in Form einer Nut ausgebildet, so dass der in diesen Abschnitt eingeschobene Seitenbereich der ersten Leiterplatte zumindest teilweise von dem U-förmigen Abschnitt umgeben ist, so dass die erste Leiterplatte mittels diesen Abschnittes gegen ein Herausfallen aus dem Aufnahmeelement gesichert werden kann. Der Abschnitt eines Halterungselements, welcher am weitesten von der Bodenplatte des Aufnahmeelements entfernt angeordnet ist, ist vorzugsweise L-förmig ausgebildet, so dass die in diesen Abschnitt eingebrachte Leiterplatte, in diesem Fall die zweite Leiterplatte, mit ihrem in den Abschnitt eingebrachten Seitenbereich aufgelegt wird und geführt ist und nicht durch das Halterungselement bzw. einen Abschnitt des Halterungselement gegen ein Herausfallen gesichert ist. Die in diesem Abschnitt angeordnete zweite Leiterplatte wird durch die an dem Aufnahmeelement angefügten Seitenelemente gegen ein Herausfallen gesichert, indem die Seitenelemente zumindest teilweise die zweite Leiterplatte übergreifen.

Bei den bisher bekannten Halterungselementen wurden alle in den Halterungselementen vorgesehenen Leiterplatten an ihren Seitenbereichen U-förmig umfasst, indem die Leiterplatten in seitlichen an dem Halterungselement vorgesehen Nuten geführt wurden. Dadurch ist es aber nicht möglich die gesamte Oberfläche der Leiterplatte vollständig zu nutzen, da ein Teil der Leiterplatte bisher immer von dem Halterungselement abgedeckt gewesen ist. Dadurch, dass es nunmehr bei der erfindungsgemäßen Moduleinheit möglich ist, dass zumindest die Leiterplatte, welche am weitesten von der Bodenplatte des Aufnahmeelements entfernt angeordnet ist, nicht mehr von dem Halterungselement abgedeckt wird, kann die gesamte Oberfläche dieser Leiterplatte unabhängig von der Positionierung in dem Aufnahmeelement für die Anordnung von Anschlüssen, beispielsweise Klemmanschlüsse, auf der Oberfläche der Leiterplatte genutzt werden. Die Anschlüsse können dadurch bis an die Randbereiche der Leiterplatte, welche an die Halterungselemente angrenzen, angeordnet werden. Zudem kann dadurch die Handhabung der Anbringung von Anschlüssen an der Leiterplatte wesentlich vereinfacht werden, da das Halterungselement nunmehr keinen zusätzlichen von der Leiterplatte abstehenden Rand mehr bildet, welcher erst von dem Anschluss überwunden werden muss, bevor der Anschluss an der Leiterplatte befestigt werden kann.

Gemäß einer weiter vorteilhaften Ausgestaltung der Erfindung weisen die zwei Halterungselemente jeweils mindestens ein Hohlkammerprofil auf, innerhalb welchem jeweils ein an den Seitenelementen vorgesehenes Rippenelement einschiebbar ist. Die Seitenelemente weisen vorzugsweise jeweils ein Rippenelement auf, welche in das Hohlkammerprofil des Halterungselements beim Befestigen der Seitenelemente an dem Aufnahmeelement eingeschoben werden können. Das Rippenelement ist dabei vorzugsweise derart ausgebildet, dass es spielfrei in das Hohlkammerprofil eingefügt werden kann. Dadurch, dass ein an den Seitenelementen vorgesehenes Rippenelement in ein Hohlkammerprofil des Halterungselements eingefügt werden kann, kann die Stabilität der Befestigung der Seitenelemente an dem Aufnahmeelement wesentlich erhöht werden, da dadurch insbesondere ein Abkippen der Seitenelemente von dem Aufnahmeelement verhindert werden kann. Durch die Ausbildung als Hohlkammerprofil kann die Stabilität der Seitenelemente selber und die Stabilität der Befestigung der Seitenelemente an dem Aufnahmeelement erhöht werden.

Weiter ist es bevorzugt vorgesehen, dass mindestens ein Befestigungselement zur Befestigung einer oder mehrerer Leiterplatten an dem Aufnahmeelement vorgesehen ist. Das Befestigungselement dient dazu zu verhindern, dass die Leiterplatten, insbesondere die zweite Leiterplatte, welche auf dem L-förmigen Abschnitt des Halterungselements aufliegt, aus dem Aufnahmeelement herausfallen können. Zudem kann das Befestigungselement die auf die Leiterplatten wirkenden Kräfte, welche durch auf der Leiterplatte angeordnete Anschlüsse hervorgerufen werden können, kompensieren. Das Befestigungselement ist dabei vorzugsweise derart ausgebildet, dass es sowohl an der Leiterplatte als auch an dem Aufnahmeelement befestigbar ist.

Das Befestigungselement ist nach einer vorteilhaften Ausgestaltung der Erfindung durch eine an der Leiterplatte vorgesehene Durchgangsöffnung führbar und mittels eines an dem Befestigungselement vorgesehenen Halteelements durch eine Drehbewegung des Befestigungselements auf einer Oberfläche der mindestens einen Leiterplatte befestigbar. Das Befestigungselement weist vorzugsweise einen länglichen Schaft auf, an welchem ein oder mehrere Halteelemente angeordnet sind. Die Durchgangsöffnung ist vorzugsweise als Langloch ausgebildet, durch welche der Schaft und das Halteelement des Befestigungselements zum Befestigen des Befestigungselements hindurchgeführt werden kann. Durch eine Drehbewegung des Befestigungselements innerhalb der Durchgangsöffnung, kann das Halteelement derart zu der Durchgangsöffnung verdreht werden, dass es nicht mehr durch die Durchgangsöffnung hindurch geführt werden kann, sondern auf der Leiterplatte zum Aufliegen kommt und auf der Oberfläche der Leiterplatte befestigt, beispielsweise durch Aufklemmen, werden kann. Das Halteelement bewirkt damit eine Verklemmung der Leiterplatte zwischen dem Halteelement und dem Aufnahmeelement. Sind mehrere Leiterplatten in dem Aufnahmeelement angeordnet, so weisen die Leiterplatten vorzugsweise jeweils eine Durchgangsöffnung auf, welche fluchtend zueinander, übereinander angeordnet sind, so dass das Befestigungselement mit seinem Schaft durch die übereinander angeordneten Durchgangslöcher geführt werden kann. Pro Leiterplatte kann das Befestigungselement dabei ein Halteelement aufweisen. Die einzelnen Halteelemente sind dabei vorzugsweise in einem bestimmten Abstand zueinander an dem Schaft angeordnet, wobei der Abstand vorzugsweise dem Abstand der Leiterplatten zueinander entspricht. Zum Befestigen des Befestigungselements wird dieses zunächst durch die Durchgangslöcher hindurch geführt, wobei das Befestigungselement dabei derart gedreht ist, dass die Halteelemente durch die Durchgangslöcher hindurch geführt werden können. Hat das Befestigungselement seine endgültige Position erreicht, so kann das Befestigungselement vorzugsweise um einen Winkel von 90° verdreht werden, so dass die einzelnen Halteelemente auf die jeweiligen Leiterplatten zum Aufliegen kommen können und dadurch ein Fixieren der Leiterplatten ermöglichen. Im Bereich der Befestigung des Befestigungselements an dem Aufnahmeelement weist das Befestigungselement vorzugsweise ein Rastelement auf, welches im Bereich des Aufnahmeelements, beispielsweise in eine Hinterschneidung im Bereich der Bodenplatte des Aufnahmeelements, durch eine 90° Drehung des Befestigungselements einhaken bzw. einrasten kann, um eine Rüttelsicherung bzw. Verdreh-/Losdrehsicherung erwirken zu können. Das Befestigungselement ist an seinem Schaft im Bereich des Rastelements vorzugsweise als ein Vierkant ausgebildet. Die Verdrehsicherung des Befestigungselements wird vorzugsweise dadurch erreicht, dass das Diagonalmaß des Vierkants am Schaft des Befestigungselements größer ist als das Breitenmaß des Aufnahmeelements im Bereich der Befestigung des Rastelements. Beim Drehen des Befestigungselements verformt sich somit das Aufnahmeelement im Bereich des Übermaßes elastisch und bewirkt so die Verdrehsicherung, was dadurch möglich ist, dass das Aufnahmeelement vorzugsweise aus einem elastischen Kunststoffmaterial hergestellt ist. Dieses Prinzip der Verdrehsicherung kann vorzugsweise auch bei den an dem Schaft des Befestigungselements vorgesehenen Halteelementen angewendet werden. Das Befestigungselement kann dabei beliebig in Längsrichtung des Aufnahmeelements bzw. in Tragschienenrichtung an der Leiterplatte bzw. an dem Aufnahmeelement befestigt werden, wobei vorzugsweise mehr als ein Befestigungselement zur Befestigung der Leiterplatte vorgesehen ist.

Weiter ist es bevorzugt vorgesehen, dass mindestens eines der Seitenelemente eine Öffnung aufweist. An dieser Öffnung kann beispielsweise eine Steckverbinderanordnung vorgesehen sein, mittels welcher es möglich ist, eine Busverbindung zwischen zwei oder mehreren Moduleinheiten ermöglichen zu können.

Ferner ist es vorzugsweise vorgesehen, dass ein oder mehrere Potential-Erdkontaktelemente vorgesehen sind. Die Potential-Erdkontaktelemente können an einer der Leiterplatten befestigt sein und mit der an dem Aufnahmeelement befestigten Tragschiene verbunden sein. Die Länge eines Potential-Erdkontaktelements kann in Abhängigkeit davon, an welcher Leiterplatte das Potential-Erdkontaktelement angeordnet ist, beliebig ausgebildet sein.

Zur Befestigung des Aufnahmeelements und/oder eines Seitenelements an einer Tragschiene ist nach einer weiter bevorzugten Ausgestaltung der Erfindung ein Fußelement vorgesehen. Das Fußelement kann unmittelbar an einem Seitenelement angeformt sein und/oder als ein separates Bauteil ausgebildet sein, welches an dem Aufnahmeelement befestigbar ist. Die Ausführung des Fußelements als ein separates Bauteil ist insbesondere dann vorteilhaft, wenn das Aufnahmeelement derart lang ausgebildet ist, dass es sich leicht durchbiegen kann. Das separate Bauteil kann jederzeit an dem Aufnahmeelement befestigt werden, ohne dass hierfür zunächst die Seitenelemente von dem Aufnahmeelement entfernt werden müssten. Das als separates Bauteil ausgebildete Fußelement ist zwischen dem Aufnahmeelement und der Tragschiene anordbar, wobei das Fußelement dabei vorzugsweise derart ausgebildet ist, dass es in das an dem Aufnahmeelement ausgebildete Stegelement einhakbar ist. Mittels beispielsweise eines an dem Fußelement schwenkbar angeordneten Verriegelungselements kann das Fußelement anschließend an der Tragschiene fixiert werden. Das als separates Bauteil ausgebildete Fußelement wird dabei vorzugsweise mit seiner Längsachse quer zur Längsachse der Tragschiene auf die Tragschiene und das Aufnahmeelement aufgerastet.

Nachfolgend wird die Erfindung unter Bezugnahme auf die anliegenden Zeichnungen anhand bevorzugter Ausführungsformen näher erläutert.

Es zeigen:
- Fig. 1: eine schematische Darstellung einer auf einer Tragschiene befestigten erfindungsgemäßen Moduleinheit;
- Fig. 2: eine schematische Darstellung eines erfindungsgemäßen Aufnahmeelements und eines daran angeordneten Seitenelements;
- Fig. 3: eine erste schematische Darstellung eines Seitenelements;
- Fig. 4: eine zweite schematische Darstellung des in Fig. 3 gezeigten Seitenelements;
- Fig. 5: eine schematische Schnittdarstellung eines an einem Aufnahmeelement befestigten Seitenelements;
- Fig. 6: eine schematische Darstellung eines Aufnahmeelements mit daran angeordneten Leiterplatten;
- Fig. 7: eine schematische Darstellung eines an den Leiterplatten vorgesehenen Befestigungselements;
- Fig. 8: eine schematische Darstellung eines als zusätzliches Bauteil vorgesehenes Fußelement befestigt an einer Tragschiene;
- Fig. 9: eine weitere schematische Darstellung des in Fig. 8 gezeigten Fußelements befestigt an einem Aufnahmeelement und einer Tragschiene;
- Fig. 10: eine schematische Darstellung einer an einem Befestigungsflansch befestigten erfindungsgemäßen Moduleinheit; und
- Fig. 11: eine schematische Darstellung des in Fig. 10 gezeigten Befestigungsflansches.

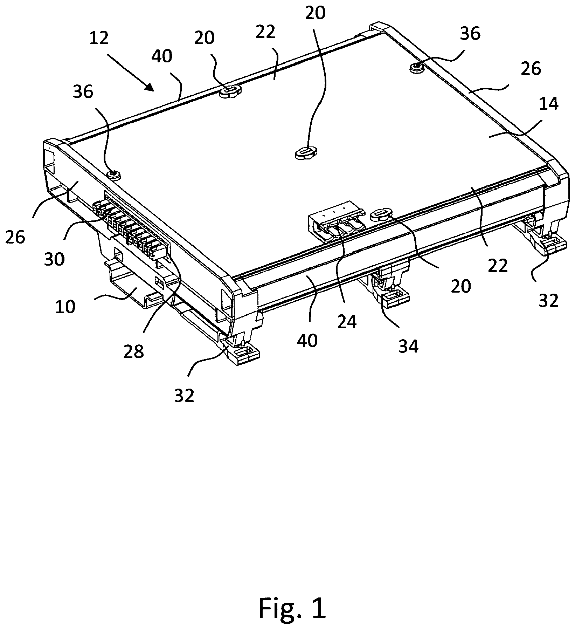

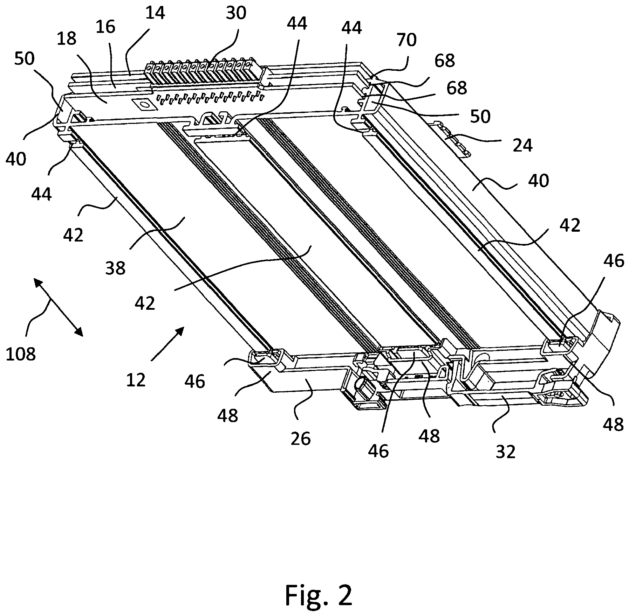

Fig. 1 zeigt eine erfindungsgemäße Moduleinheit, welche an einer Tragschiene 10 befestigt ist. Die Moduleinheit weist ein, wie in Fig. 2 erkennbares, wannenförmiges Aufnahmeelement 12 zur Aufnahme von mindestens einer Leiterplatte 14 auf, wobei das Aufnahmeelement 12 als ein Extrusionsprofil ausgebildet ist. Das Aufnahmeelement 12 wird an seinen beiden Längsseiten von jeweils einem Halterungselement 40 begrenzt, welches mehrere Einschubbereiche bzw. Abschnitte 68, 70 aufweist, in welche die Leiterplatten 14 zur Befestigung an dem Aufnahmeelement 12 eingeschoben werden.

Die in Fig. 1 gezeigte Moduleinheit weist drei Leiterplatten 14, 16, 18 auf, welche, wie in Fig. 2 zu erkennen, übereinander in das Aufnahmeelement 12 eingeschoben sind. In Fig. 1 ist lediglich die zweite Leiterplatte 14 zu sehen, welche die oberste Leiterplatte darstellt, und somit das Aufnahmeelement 12 bzw. die Moduleinheit nach oben hin abschließt. Diese zweite Leiterplatte 14 liegt auf den Halterungselementen 40 auf und ist mittels drei Befestigungselementen 20 an dem Aufnahmeelement 12 befestigt. Dadurch, dass die zweite Leiterplatte 14 auf den Halterungselementen 40 aufliegt und nicht an seinen Seitenbereichen 22 von dem Halterungselementen 40 nach oben hin abgedeckt wird, ist es möglich, Anschlüsse 24, beispielsweise Klemmanschlüsse, bis an den Rand der Seitenbereiche 22 der Leiterplatte 14 anzuordnen, wie dies in Fig. 1 dargestellt ist, so dass ein größerer Bereich der Oberfläche der Leiterplatte 14 für Anschlüsse 24 genutzt werden kann. In dem hier gezeigten Beispiel sind Befestigungselemente 20 an den Seitenbereichen 22 und mittig von der Leiterplatte 14 vorgesehen.

Um ein Herausrutschen der Leiterplatten 14, 16, 18 aus dem Aufnahmeelement 12 zu verhindern, ist an den beiden Querseiten des Aufnahmeelements 12 jeweils ein Seitenelement 26 vorgesehen. Die Seitenelemente 26 können auf das Aufnahmeelement 12 aufgeschoben werden und dort durch ein Einrasten an dem Aufnahmeelement 12 befestigt werden. Die Seitenelemente 26 sind derart ausgebildet, dass sie die zweite Leiterplatte 14 teilweise übergreifen und dadurch ein Herausfallen der Leiterplatte 14 aus dem Aufnahmeelement 12 verhindern.

Die Seitenelement 26 können ein oder mehrere Öffnungen 28 aufweisen, in welche beispielsweise eine Steckverbinderanordnung 30, wie in Fig. 1 gezeigt, anordbar ist, um eine Moduleinheit mit einer anderen Moduleinheit verbinden zu können.

Die Seitenelemente 26 weisen jeweils ein Fußelement 32 auf, mittels welchen die Seitenelemente 26 und damit die Moduleinheit an einer Tragschiene 10 befestigbar sind. Zusätzlich zu den Fußelementen 32 an den Seitenelementen 26 kann ein Fußelement 34 als ein separates Bauteil vorgesehen sein, welches zwischen dem Aufnahmeelement 12 und der Tragschiene 10 befestigbar ist.

Ferner können, wie in Fig. 1 gezeigt, Potential-Erdkontaktelemente 36 vorgesehen sein, welche an einer Leiterplatte 14 befestigt sind und mit der an dem Aufnahmeelement 12 befestigten Tragschiene 10 verbunden sind.

Fig. 2 zeigt eine noch nicht fertig zusammengesetzte Moduleinheit. Das Aufnahmeelement 12 der Moduleinheit ist aus einer Bodenplatte 38 und zwei an der Bodenplatte 38 angeordneter Halterungselemente 40 gebildet. An der Bodenplatte 38, insbesondere an der Unterseite der Bodenplatte 38, sind drei Stegelemente 42 ausgebildet, welche sich mit ihrer Längsachse entlang der Einschubrichtung 108 der Leiterplatten 14, 16, 18 erstrecken, wobei zwei Stegelement 42 an den Randbereichen des Aufnahmeelements 12 und ein Stegelement 42 mittig an dem Aufnahmeelement 12 vorgesehen sind. In den Stegelementen 42 sind nutförmige Ausnehmungen 44 eingebracht, welche sich quer zur Längsachse der Stegelemente 42 erstrecken. In die nutförmigen Ausnehmungen 44 können an den Seitenelementen 26 vorgesehene Rastmittel 46 eingerastet werden, indem die Seitenelemente 26 auf das Aufnahmeelement 12 aufgeschoben werden. Zum gezielten Aufschieben der Seitenelemente 26 weisen diese Führungselemente 48 auf, welche auf die Stegelemente 42 aufgeschoben werden können. Die Stegelemente 42 sind dabei T-förmig ausgebildet und die Führungselemente 48 sind U-förmig mit nach innen gebogenen Endbereichen ausgebildet, so dass die Führungselemente 48 die Stegelemente 42 zumindest teilweise umgreifen können. Die Rastmittel 46 sind innerhalb der Führungselemente 48 ausgebildet.

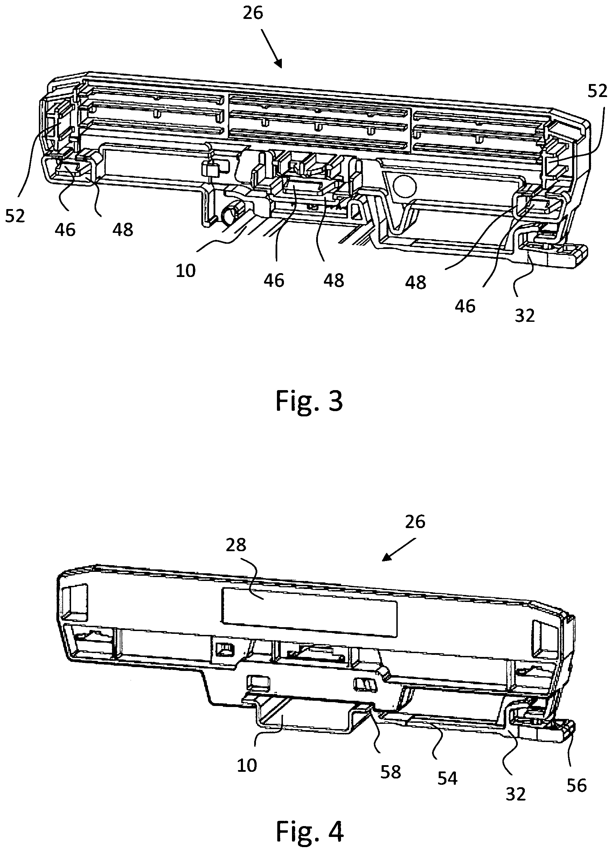

Die Halterungselemente 40, welche vorzugsweise zusammen mit der Bodenplatte 38 in einem Stück extrudiert werden, weisen jeweils ein Hohlkammerprofil 50 auf, in welchen an den Seitenelementen 26 vorgesehene Rippenelemente 52, wie in Fig. 3 gezeigt, eingreifen können, und dadurch die Stabilität der Verbindung der Seitenelemente 26 an dem Aufnahmeelement 12 verbessern können.

Ferner weisen die Halterungselemente 40 einzelne Abschnitte 68, 70 auf, in welche die einzelnen Leiterplatten 14, 16, 18 eingeschoben bzw. eingelegt werden können. Die zwei Halterungselemente 40 sind dabei vorzugsweise derart geformt, dass die erste Leiterplatte 18 und die dritte Leiterplatte 16 an zwei sich gegenüberliegenden Seitenbereichen der ersten Leiterplatte 18 bzw. der dritten Leiterplatte 16 jeweils von einem der zwei Halterungselementen 40 U-förmig umgeben ist und die zweite Leiterplatte 14 mit zwei sich gegenüberliegenden Seitenbereichen der zweiten Leiterplatte 14 auf den zwei Halterungselementen 26 aufliegt. Die Abschnitte 68 eines Halterungselements 40, in welchen die erste Leiterplatte 18 und die dritte Leiterplatte 16 eingeschoben ist, ist U-förmig in Form einer Nut ausgebildet, so dass der in diese Abschnitte 68 eingeschobene Seitenbereich der ersten Leiterplatte 18 und der dritten Leiterplatte 16 jeweils zumindest teilweise von einem U-förmigen Abschnitt 68 umgeben ist, so dass die erste Leiterplatte 18 und die dritte Leiterplatte 16 mittels dieser Abschnitte 68 gegen ein Herausfallen aus dem Aufnahmeelement 12 gesichert sind. Der Abschnitt 70 eines Halterungselements 40, welcher am weitesten von der Bodenplatte 38 des Aufnahmeelements 12 entfernt angeordnet ist, ist vorzugsweise L-förmig ausgebildet, so dass die in diesen Abschnitt 70 eingebrachte zweite Leiterplatte 14 mit ihrem in den Abschnitt 70 eingebrachten Seitenbereich aufgelegt wird und geführt ist und nicht durch das Halterungselement 40 bzw. einen Abschnitt 70 des Halterungselements 40 gegen ein Herausfallen gesichert ist. Die in diesem Abschnitt 70 angeordnete zweite Leiterplatte 14 wird durch die an dem Aufnahmeelement 12 angefügten Seitenelemente 26 gegen ein Herausfallen gesichert, indem die Seitenelemente 26 zumindest teilweise die zweite Leiterplatte 14 übergreifen.

Fig. 3 zeigt ein Seitenelement 26 mit der Seitenfläche, mittels welcher das Seitenelement 26 an dem Aufnahmeelement 12 befestigbar ist, wobei an dieser Seitenfläche die Rippenelemente 52, die Führungselemente 48 und die daran angeordneten Rastmittel 46 angeordnet sind.

Fig. 4 zeigt ein Seitenelement 26 mit der Seitenfläche, welche sich im montierten Zustand von dem Aufnahmeelement 12 wegerstreckt. An diesem Seitenelement 26 ist die Öffnung 28 erkennbar, welche in diesem hier gezeigten Beispiel als eine Durchbruchstelle ausgebildet ist, um beispielsweise eine Steckverbinderanordnung 30 an einer Leiterplatte 14, 16, 18 anordnen zu können.

In Fig. 3 und 4 ist weiter erkennbar, dass die Seitenelemente 26 an ihrer Unterseite ein Fußelement 32 aufweisen, mittels welchen die Seitenelemente 26 an einer Tragschiene 10 befestigbar sind. Hierfür weist das Fußelement ein Verriegelungselement 54 auf, welches schwenkbeweglich an dem Seitenelement 26 gelagert ist. Das Verriegelungselement 54 weist an seinem ersten freien Ende eine Öffnung 56 auf, über welche das Verriegelungselement 54 mittels eines Werkzeuges, beispielsweise eines Schraubendrehers, betätigbar ist. An seinem anderen freien Ende weist das Verriegelungselement 54 einen Rasthaken 58 auf, wobei der Rasthaken 58 hinter einer Kante der Tragschiene 10 einrastet, so dass das Fußelement 32 und damit das Seitenelement 26 auf die Tragschiene 10 aufgeklemmt werden kann.

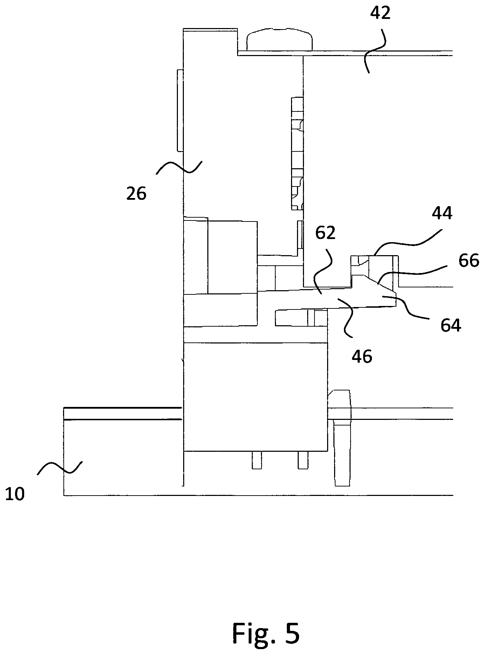

Fig. 5 zeigt eine Schnittdarstellung der Befestigung eines Seitenelements 26 an einem Aufnahmeelement 12, wobei hierbei insbesondere das Eingreifen des Rastmittels 46 in die nutförmige Ausnehmung 44 an einem Stegelement 42 gezeigt ist. Das Rastmittel 46 ist federnd ausgebildet und weist einen länglichen Federarm 62 auf, welcher an seinem einen freien Ende einen Rasthaken 64 mit einer angeschrägten Fläche 66 aufweist. Zum Befestigen des Rastmittels 46 in der nutförmigen Ausnehmung 44 wird der Federarm 62 entlang des Stegelements 42 geführt, bis der Rasthaken 64 in die Ausnehmung 44 eingreifen kann. Zum Lösen des Rastmittels 46 aus der Ausnehmung 44 kann der Rasthaken 64 bzw. der Federarm 62 mittels eines Werkzeuges, welches in einen Spalt zwischen der angeschrägte Fläche 66 und der Ausnehmung 44 eingreifen kann, nach unten gebogen werden, bis der Rasthaken 64 aus der Ausnehmung 44 gelöst ist. Anschließend kann das Seitenelement 26 mit dem Rastmittel 46 von dem Stegelement 42 abgezogen werden.

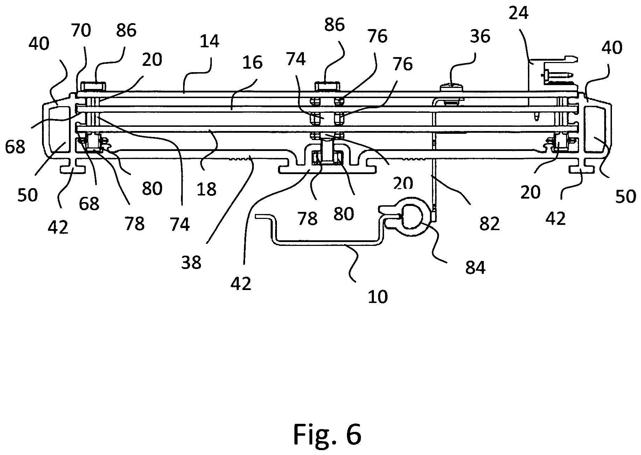

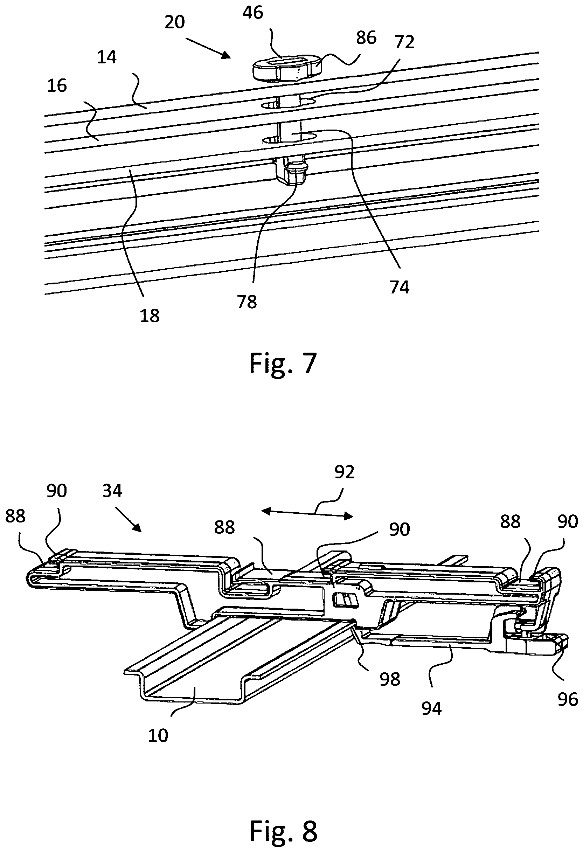

In Fig. 6 ist das Aufnahmeelement 12 mit den darin angeordneten Leiterplatten 14, 16, 18 gezeigt, welche mittels der Abschnitte 68, 70 in dem Aufnahmeelement 12 gehalten werden. Zusätzlich hierzu sind die Leiterplatten 14, 16, 18 mit Befestigungselementen 20 an dem Aufnahmeelement 12 fixiert. Zur Montage der Befestigungselemente 20 weisen die Leiterplatten 14, 16, 18 Durchgangsöffnungen 72 auf, welche wie in Fig. 8, erkennbar, als Langloch ausgebildet sind. Das Befestigungselement 20 weist einen länglichen Schaft 74 auf, an welchem ein oder mehrere Haltelemente 76, 86 angeordnet sind. Zum Befestigen des Befestigungselements 20 kann der Schaft 74 und eventuell ein oder mehrere der an dem Schaft 74 angeordneten Halteelemente 76 durch die Durchgangsöffnung 72 hindurchgeführt werden. Das an dem freien Ende des Schafts vorgesehene Halteelement 86 weist eine größere Umfangsfläche auf als die übrigen Halteelemente 76, wobei die Umfangsfläche des Halteelements 86 größer ist als die Durchgangsöffnungen 72 in den Leiterplatten 14, 16, 18, damit dieses Halteelement 86 nicht durch die Durchgangslöcher 72 hindurchgeführt werden kann, sondern auf der obersten in dem Aufnahmeelement 12 vorgesehenen Leiterplatte 14 zum Aufliegen kommt. Dadurch wird verhindert, dass das gesamte Befestigungselement 20 ungewollt vollständig in die Durchgangsöffnungen 72 hineinrutschen kann. Die Halteelemente 76 sind dabei vorzugsweise um einen Winkel von 90° versetzt zu dem Halteelement 86 an dem Schaft 74 angeordnet. Durch eine Drehbewegung des Befestigungselements 20 innerhalb der Durchgangsöffnung 72, kann das Halteelement 76 derart zu der Durchgangsöffnung 72 verdreht werden, dass es nicht mehr durch die Durchgangsöffnung 72 hindurch geführt werden kann und dadurch auf einer der Leiterplatten 14, 16, 18 zum Aufliegen kommt und dadurch auf der Oberfläche der jeweiligen Leiterplatte 14, 16, 18 aufgeklemmt wird. Das Halteelement 76 bewirkt damit eine Verklemmung der Leiterplatte 14, 16, 18 zwischen dem Halteelement 76 und dem Aufnahmeelement 12. Sind mehrere Leiterplatten 14, 16, 18, wie dies hier gezeigt ist, in dem Aufnahmeelement 12 angeordnet, so weisen die Leiterplatten 14, 16, 18 vorzugsweise jeweils pro Befestigungselement 20 eine Durchgangsöffnung 72 auf, welche fluchtend zueinander, übereinander angeordnet sind, so dass das Befestigungselement 20 mit seinem Schaft 74 durch die übereinander angeordneten Durchgangslöcher 72 geführt werden kann. Pro Leiterplatte 14, 16, 18 kann das Befestigungselement 20 dabei jeweils ein Halteelement 76 aufweisen, wie dies hier bei dem mittig angeordneten Befestigungselement 20 der Fall ist. Die einzelnen Halteelemente 76 sind dabei vorzugsweise in einem bestimmten Abstand zueinander an dem Schaft 72 angeordnet, wobei der Abstand vorzugsweise dem Abstand der Leiterplatten 14, 16, 18 zueinander entspricht. Zum Befestigen des Befestigungselements 20 wird dieses zunächst durch die Durchgangsöffnungen 72 hindurch geführt, wobei das Befestigungselement 20 dabei derart gedreht ist, dass die Halteelemente 76 durch die Durchgangsöffnungen 72 hindurch geführt werden können. Hat das Befestigungselement 20 seine endgültige Position erreicht, so kann das Befestigungselement 20 vorzugsweise um einen Winkel von 90° verdreht werden, so dass die einzelnen Halteelemente 76 auf die jeweiligen Leiterplatten 14, 16, 18 zum Aufliegen kommen können und dadurch ein Fixieren der Leiterplatten 14, 16, 18 ermöglichen. Im Bereich der Befestigung des Befestigungselements 20 an dem Aufnahmeelement 12 weist das Befestigungselement 20 vorzugsweise ein Rastelement 78 auf, welches im Bereich des Aufnahmeelements 12, beispielsweise in eine Hinterschneidung 80 an der Bodenplatte 38 des Aufnahmeelements 12, einhaken kann.

Bei dem in Fig. 6 gezeigten Ausführungsbeispiel ist jeweils ein Befestigungselement 20 an den Seitenbereichen 22 der Leiterplatten 14, 16, 18 vorgesehen, wobei dies Befestigungselemente 20 lediglich die zweite Leiterplatte 14 durch ein Halteelement 76 festklemmen, da die erste und die dritte Leiterplatte 18, 16 durch die U-förmigen Abschnitte 68 der Halterungselemente 40 in ihrer Position in dem Aufnahmeelement 12 gehalten werden. Das in der Mitte der Leiterplatten 14, 16, 18 vorgesehene Befestigungselement 20 weist hingegen für jede der drei Leiterplatten 14, 16, 18 ein Halteelement 76, 86 auf, so dass alle drei Leiterplatten 14, 16, 18 mittig an dem Aufnahmeelement 12 fixiert werden, wodurch durch die Leiterplatten verursachte Klappergeräusche verhindert werden können.

Ferner ist in Fig. 6 ein Potential-Erdkontaktelement 36 gezeigt, welches auf der obersten Leiterplatte 14 befestigt ist und einen Metallarm 82 aufweist, welcher über eine Klemme 84 an der Tragschiene 10 befestigt ist.

Fig. 7 zeigt eine Detaildarstellung eines an den Seitenbereichen 22 der Leiterplatten 14, 16, 18 vorgesehenen Befestigungselements 20, wobei dieses Befestigungselement 20 lediglich ein Halteelement 86 aufweist, welches im gezeigten befestigten Zustand auf der zweiten Leiterplatte 14 aufliegt. Das Rastelement 78, welches in einer Hinterschneidung 80 des Aufnahmeelements 12 eingreifen kann, ist um einen Winkel von 90° versetzt zu dem Halteelement 86 an dem Schaft 74 angeordnet.

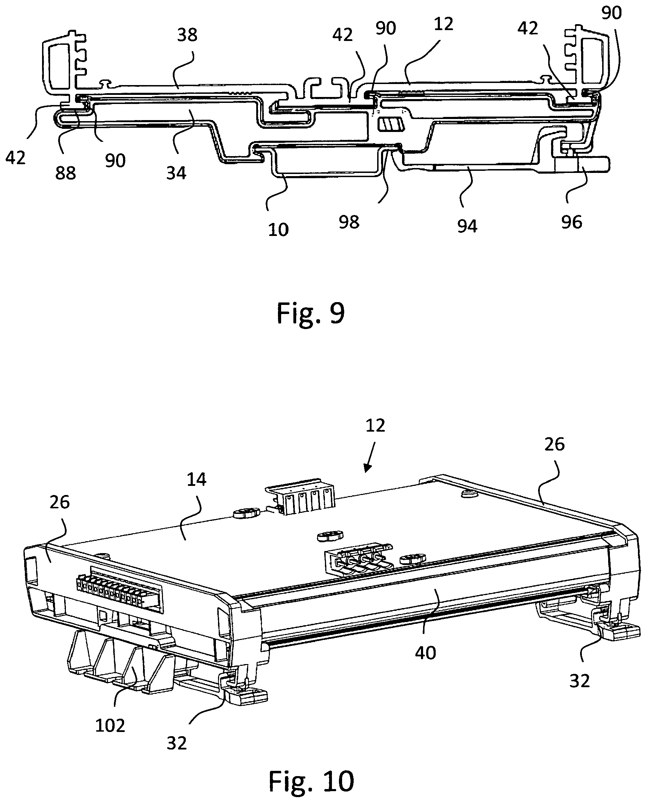

In Fig. 8 und Fig. 9 ist ein Fußelement 34 in Form eines zusätzlichen Bauteils dargestellt, welches zwischen einem Aufnahmeelement 12 und einer Tragschiene 10 zur Stabilisierung der Moduleinheit auf der Tragschiene 10 dienen kann. Das Fußelement 34 ist vorzugsweise als ein längliches, flaches Profil ausgebildet. Das Fußelement 34 weist mehrere Ausnehmungen 88 auf, welche in die an der Bodenplatte 38 des Aufnahmeelements 12 vorgesehenen Stegelemente 42 eingreifen können. Die Ausnehmungen 88 weisen hierfür jeweils einen Hinterschnitt 90 auf, welche durch eine Verschiebung des Fußelements 34 entlang seiner Längsrichtung, mit dem Pfeil 92 dargestellt, auf die Stegelemente 42 aufschiebbar bzw. von den Stegelementen 42 abschiebbar sind und in der aufgeschobenen Position in eine oder mehrere der Ausnehmungen 88 der Stegelemente 42 verrastbar sind. Vorzugsweise erfolgt eine Verrastung des Fußelements 34 in der mittig an dem Fußelement 34 vorgesehenen Ausnehmung 88 vorzugsweise mittels eines in der Ausnehmung 88 vorgesehenen Rasthakens, hier nicht dargestellt. Mittels eines an dem Fußelement 34 schwenkbar angeordneten Verriegelungselements 94 kann das Fußelement 34 an der Tragschiene 10 fixiert werden. Das Verriegelungselement 94 weist an seinem ersten freien Ende eine Öffnung 96 auf, über welche das Verriegelungselement 94 mittels eines Werkzeuges, beispielsweise eines Schraubendrehers, betätigbar ist. An seinem anderen freien Ende weist das Verriegelungselement 94 einen Rasthaken 98 auf, wobei der Rasthaken 98 hinter einer Kante der Tragschiene 10 einrastet, so dass das Fußelement 34 auf die Tragschiene 10 aufgeklemmt werden kann. In Fig. 9 ist das Fußelement 34 in einem an dem Aufnahmeelement 12 und der Tragschiene 10 befestigten Zustand gezeigt.

Fig. 10 zeigt eine erfindungsgemäße Moduleinheit, welche nicht auf einer Tragschiene, sondern an einem Befestigungsflansch 102 montiert ist.

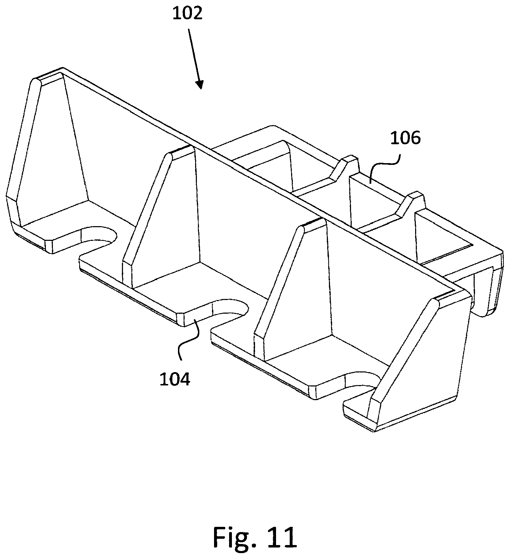

Fig. 11 zeigt ein Beispiel für einen derartigen Befestigungsflansch 102 im Detail, wobei der Befestigungsflansch 102 mehrere Bohrungen 104 zur Aufnahme von Schrauben aufweist, mittels welchen der Befestigungsflansch 102 und damit die Moduleinheit beispielsweise an einer Wand eines Schaltschrankes montiert werden kann. Der Befestigungsflansch 102 kann, beispielsweise mittels eines Einhakelements 106, an einem an dem Aufnahmeelement 12 angeordneten Seitenelement 26 befestigt werden, so dass die Seitenelemente 26 auf einen Befestigungsflansch 106 wie auf eine Tragschiene aufgerastet werden können. Vorteilhafterweise müssen zur Demontage der Seitenelemente 26 von dem Befestigungsflansch 106 der Befestigungsflansch 106 nicht abgeschraubt werden.

**Bezugszeichenliste**

| | |
|---|---|
| Tragschiene | 10 |
| Aufnahmeelement | 12 |
| Zweite Leiterplatte | 14 |
| Dritte Leiterplatte | 16 |
| Erste Leiterplatte | 18 |
| Befestigungselement | 20 |
| Seitenbereich | 22 |
| Anschluss | 24 |
| Seitenelement | 26 |
| Öffnung | 28 |
| Steckverbinderanordnung | 30 |
| Fußelement | 32 |
| Fußelement | 34 |
| Potential-Erdkontaktelement | 36 |
| Bodenplatte | 38 |
| Halterungselement | 40 |
| Stegelement | 42 |
| Ausnehmung | 44 |
| Rastmittel | 46 |
| Führungselement | 48 |
| Hohlkammerprofil | 50 |
| Rippenelement | 52 |
| Verriegelungselement | 54 |
| Öffnung | 56 |
| Rasthaken | 58 |
| Federarm | 62 |
| Rasthaken | 64 |
| Angeschrägte Fläche | 66 |
| Abschnitt | 68 |
| Abschnitt | 70 |
| Durchgangsöffnung | 72 |
| Schaft | 74 |
| Halteelement | 76 |
| Rastelement | 78 |
| Hinterschneidung | 80 |
| Metallarm | 82 |
| Klemme | 84 |
| Halteelement | 86 |
| Ausnehmung | 88 |
| Hinterschnitt | 90 |
| Längsrichtung | 92 |
| Verriegelungselement | 94 |
| Öffnung | 96 |
| Rasthaken | 98 |
| Befestigungsflansch | 102 |
| Bohrung | 104 |
| Einhakelement | 106 |
| Einschubrichtung | 108 |

## Patentansprüche

1. Moduleinheit, umfassend
ein wannenförmiges Aufnahmeelement (12) zur Aufnahme ein oder mehrerer Leiterplatten (14, 16, 18), wobei das Aufnahmeelement (12) eine Bodenplatte (38) und zwei an der Bodenplatte (38) angeordnete Halterungselemente (40) aufweist, wobei die Halterungselemente (40) jeweils mehrere Einschubbereiche (68, 70) aufweisen, in welche die ein oder mehreren Leiterplatten (14) zur Befestigung an dem Aufnahmeelement (12) eingeschoben werden, und
zwei an dem Aufnahmeelement (12) anordbare Seitenelemente (26) zum Verhindern eines seitlichen Herausrutschens der ein oder mehreren Leiterplatten (14) aus den Halterungselementen (40) an den beiden offenen Seitenbereichen des Aufnahmeelementes (12), wobei das Aufnahmeelement (12) aus einem Extrusionsprofil gebildet ist, wobei das Aufnahmeelement (12) mindestens zwei Ausnehmungen (44) aufweist, innerhalb welcher die Seitenelemente (26) an dem Aufnahmeelement (12) durch Einrasten befestigbar sind,
**dadurch gekennzeichnet, dass**
an einer Unterseite der Bodenplatte (38) des Aufnahmeelementes (12) ein Stegelement (42) ausgebildet ist, welches sich mit seiner Längsachse entlang einer Einschubrichtung der Leiterplatten (14, 16, 18) erstreckt, wobei die mindestens zwei Ausnehmungen (44) des Aufnahmeelementes (12) an dem Stegelement (42) ausgebildet sind, wobei sich die Ausnehmungen (44) quer zur Längsachse des Stegelements (42) erstrecken.

2. Moduleinheit nach Anspruch 1,
**dadurch gekennzeichnet, dass**
die Seitenelemente (26) Rastmittel (46) zum Befestigen der Seitenelemente (26) in den Ausnehmungen (44) des Aufnahmeelements (12) aufweisen.

3. Moduleinheit nach Anspruch 1 oder 2,
**dadurch gekennzeichnet, dass**
die Seitenelemente (26) jeweils mittels eines an den Seitenelementen (26) vorgesehenen Führungselementes (48) auf das Stegelement (42) aufschiebbar sind.

4. Moduleinheit nach Anspruch 3,
**dadurch gekennzeichnet, dass**
das Rastmittel (46) eines Seitenelements (26) im Bereich des Führungselements (48) vorgesehen ist.

5. Moduleinheit nach einem der Ansprüche 1 bis 4,
**dadurch gekennzeichnet, dass**
mindestens eine erste Leiterplatte (18) und eine zweite Leiterplatte (14) in dem Aufnahmeelement aufgenommen sind, wobei das Aufnahmeelement (12) zwei Halterungselemente (40) zur Aufnahme der ersten und der zweiten Leiterplatte (18, 14) aufweist, wobei die zwei Halterungselemente (40) derart geformt sind, dass die erste Leiterplatte (18) an zwei sich gegenüberliegenden Seitenbereichen (22) der ersten Leiterplatte (18) jeweils von einem der zwei Halterungselemente (40) U-förmig umgeben ist und die zweite Leiterplatte (14) mit zwei sich gegenüberliegenden Seitenbereichen (22) der zweiten Leiterplatte (14) auf den zwei Halterungselementen (40) aufliegt.

6. Moduleinheit nach Anspruch 5,
**dadurch gekennzeichnet, dass**
die zwei Halterungselemente (40) jeweils mindestens ein Hohlkammerprofil (50) aufweisen, innerhalb welchen jeweils ein an den Seitenelementen (26) vorgesehenes Rippenelement (52) einschiebbar ist.

7. Moduleinheit nach einem der Ansprüche 1 bis 6,
**dadurch gekennzeichnet, dass** die Moduleinheit mindestens ein Befestigungselement (20) zur Befestigung einer oder mehrerer Leiterplatten (14, 16, 18) an dem Aufnahmeelement (12) aufweist.

8. Moduleinheit nach Anspruch 7,
**dadurch gekennzeichnet, dass**
das Befestigungselement (20) durch eine an der Leiterplatte (14, 16, 18) vorgesehene Durchgangsöffnung (72) führbar ist und mittels eines an dem Befestigungselement (20) vorgesehenen Halteelements (76, 86) durch eine Drehbewegung des Befestigungselements (20) auf einer Oberfläche der mindestens einen Leiterplatte (14, 16, 18) befestigbar ist.

9. Moduleinheit nach einem der Ansprüche 1 bis 8,
**dadurch gekennzeichnet, dass**
mindestens eines der zwei Seitenelemente (26) eine Öffnung (28) aufweist.

10. Moduleinheit nach einem der Ansprüche 1 bis 9,
**dadurch gekennzeichnet, dass** die Moduleinheit ein oder mehrere Potential-Erdkontaktelemente (36) aufweist.

11. Moduleinheit nach einem der Ansprüche 1 bis 10,
**dadurch gekennzeichnet, dass** die Moduleinheit ein Fußelement (32, 34) zur Befestigung des Aufnahmeelements (12) und/oder eines Seitenelements (26) an einer Tragschiene (10) aufweist.

12. Verfahren zur Herstellung einer Moduleinheit nach einem der Ansprüche 1 bis 11, bei welchem Aufnahmeelemente (12) von einem Extrusionsprofil abgelängt werden, wobei gleichzeitig beim Ablängen Ausnehmungen (44) in die Aufnahmeelemente eingebracht werden.

13. Verfahren nach Anspruch 12, **dadurch gekennzeichnet, dass** zum Ablängen und zum Einbringen der Ausnehmungen (44) eine Sägevorrichtung verwendet wird, wobei über ein Hauptsägeblatt der Sägevorrichtung Aufnahmeelemente (12) von dem Extrusionsprofil abgelängt werden und über zwei zusätzliche an der Sägevorrichtung vorgesehene Sägeblätter jeweils eine Ausnehmung an einem Ende des abzulängenden Aufnahmeelementes (12) und an einem Anfang eines nächsten abzulängenden Aufnahmeelementes eingebracht werden.

## Claims

1. Module unit, comprising
a tub-shaped receptacle element (12) for receiving one or a plurality of circuit boards (14, 16, 18), wherein the receptacle element (12) has a base plate (38) and two mounting elements (40) that are disposed on the base plate (38), wherein the mounting elements (40) have in each case a plurality of plug-in regions (68, 70) into which the one or the plurality of circuit boards (14) are plugged for fastening to the receptacle element (12); and
two lateral elements (26) on the two open lateral regions of the receptacle element (12), for preventing one or a plurality of circuit boards (14) from sliding laterally out of the mounting elements (40), said lateral elements (26) being disposable on the receptacle element (12);
wherein the receptacle element (12) is formed from an extruded profile, wherein the receptacle element (12) has at least two clearances (44) within which the lateral elements (26) are fastenable to the receptacle element (12) by latching,
**characterized in that**
a web element (42) is configured on a lower side of the base plate (38) of the receptacle element (12), said web element (42) by way of the longitudinal axis thereof extending along a plug-in direction of the circuit boards (14, 16, 18), wherein the at least two clearances (44) of the receptacle element (12) are configured on the web element (42), wherein the clearances (44) extend transversely to the longitudinal axis of the web element (42).

2. Module unit according to Claim 1,
**characterized in that**
the lateral elements (26) have latching means (46) for fastening the lateral elements (26) in the clearances (44) of the receptacle element (12).

3. Module unit according to Claim 1 or 2,
**characterized in that**
the lateral elements (26) are in each case push-fittable onto the web element (42) by means of a guiding element (48) that is provided on the lateral elements (26).

4. Module unit according to Claim 3,
**characterized in that**
the latching means (46) of a lateral element (26) is provided in the region of the guiding element (48) .

5. Module unit according to one of Claims 1 to 4,
**characterized in that**
at least one first circuit board (18) and one second circuit board (14) are received in the receptacle element, wherein the receptacle element (12) has two mounting elements (40) for receiving the first circuit board (18) and the second circuit board (14), wherein the two mounting elements (40) are shaped in such a manner that the first circuit board (18) on two mutually opposite lateral regions (22) of the first circuit board (18) is in each case surrounded in a U-shaped manner by one of the two mounting elements (40), and the second circuit board (14) by way of two mutually opposite lateral regions (22) of the second circuit board (14) bears on the two mounting elements (40).

6. Module unit according to Claim 5,
**characterized in that**
the two mounting elements (40) have in each case at least one hollow-section profile (50) within which in each case one ribbed element (52) that is provided on the lateral elements (26) is plug-fittable.

7. Module unit according to one of Claims 1 to 6,
**characterized in that**
the module unit has at least one fastening element (20) for fastening one or a plurality of circuit boards (14, 16, 18) to the receptacle element (12) .

8. Module unit according to Claim 7,
**characterized in that**
the fastening element (20) is guidable through a passage opening (72) that is provided on the circuit board (14, 16, 18), and by means of a holding element (76, 86) that is provided on the fastening element (20) is fastenable to a surface of the at least one circuit board (14, 16, 18) by way of a rotating movement of the fastening element (20).

9. Module unit according to one of Claims 1 to 8,
**characterized in that**
at least one of the two lateral elements (26) has an opening (28).

10. Module unit according to one of Claims 1 to 9,
**characterized in that**
the module unit has one or a plurality of potential-to-earth contact elements (36).

11. Module unit according to one of Claims 1 to 10,
**characterized in that**
the module unit has a foot element (32, 34) for fastening the receptacle element (12) and/or a lateral element (26) to a support rail (10).

12. Method for producing a module unit according to one of Claims 1 to 11, in which receptacle elements (12) are cut to length from an extruded profile, wherein simultaneously with the cutting-to-length, clearances (44) are incorporated into the receptacle elements.

13. Method according to Claim 12, **characterized in that** a saw device is used for cutting-to-length and for incorporating the clearances (44), wherein receptacle elements (12) are cut to length from the extruded profile by way of a main saw blade of the saw device, and in each case one clearance at an end of the receptacle element (12) to be cut to length and at a beginning of a next receptacle element to be cut to length are incorporated by way of two additional saw blades that are provided on the saw device.

## Revendications

1. Unité modulaire, comprenant
un élément de réception en forme de bac (12) pour recevoir une ou plusieurs cartes à circuits imprimés (14, 16, 18), l'élément de réception (12) présentant une plaque de fond (38) et deux éléments de retenue (40) disposés sur la plaque de fond (38), les éléments de retenue (40) présentant chacun plusieurs régions d'insertion (68, 70) dans lesquels la ou les cartes à circuits imprimés (14) sont insérées de manière à être fixées sur l'élément de réception (12), et
deux éléments latéraux (26) pouvant être disposés au niveau de l'élément de réception (12) pour empêcher que la ou les cartes à circuits imprimés (14) ne ressortent latéralement des éléments de retenue (40) au niveau des deux régions latérales ouvertes de l'élément de réception (12), l'élément de réception (12) étant formé d'un profil extrudé, l'élément de réception (12) présentant au moins deux évidements (44) à l'intérieur desquels les éléments latéraux (26) peuvent être fixés par encliquetage à l'élément de réception (12),
**caractérisé en ce**
**qu'**au niveau d'un côté inférieur de la plaque de fond (38) de l'élément de réception (12) est réalisé un élément de nervure (42) qui s'étend avec son axe longitudinal le long d'une direction d'insertion des cartes à circuits imprimés (14, 16, 18), les au moins deux évidements (44) de l'élément de réception (12) étant réalisés au niveau de l'élément de nervure (42), les évidements (44) s'étendant transversalement à l'axe longitudinal de l'élément de nervure (42).

2. Unité modulaire selon la revendication 1,
**caractérisée en ce que**
les éléments latéraux (26) présentent des moyens d'encliquetage (46) pour la fixation des éléments latéraux (26) dans les évidements (44) de l'élément de réception (12).

3. Unité modulaire selon la revendication 1 ou 2,
**caractérisée en ce que**
les éléments latéraux (26) peuvent être enfoncés sur l'élément de nervure (42) à chaque fois au moyen d'un élément de guidage (48) prévu sur les éléments latéraux (26).

4. Unité modulaire selon la revendication 3,
**caractérisée en ce que**
le moyen d'encliquetage (46) d'un élément latéral (26) est prévu dans la région de l'élément de guidage (48).

5. Unité modulaire selon l'une quelconque des revendications 1 à 4,
**caractérisée en ce**
**qu'**au moins une première carte à circuits imprimés (18) et une deuxième carte à circuits imprimés (14) sont reçues dans l'élément de réception, l'élément de réception (12) présentant deux éléments de retenue (40) pour recevoir la première et la deuxième carte à circuits imprimés (18, 14), les deux éléments de retenue (40) étant formés de telle sorte que la première carte à circuits imprimés (18) soit entourée en forme de U au niveau de deux régions latérales opposées (22) de la première carte à circuits imprimés (18) à chaque fois par l'un des deux éléments de retenue (40) et que la deuxième carte à circuits imprimés (14) repose avec deux régions latérales (22) opposées de la deuxième carte à circuits imprimés (14) sur les deux éléments de retenue (40).

6. Unité modulaire selon la revendication 5,
**caractérisée en ce que**
les deux éléments de retenue (40) présentent à chaque fois au moins un profil de chambre creuse (50) à l'intérieur duquel peut à chaque fois être enfoncé un élément d'ailette (52) prévu au niveau des éléments latéraux (26).

7. Unité modulaire selon l'une quelconque des revendications 1 à 6, **caractérisée en ce que** l'unité modulaire présente au moins un élément de fixation (20) pour la fixation d'une ou plusieurs cartes à circuits imprimés (14, 16, 18) à l'élément de réception (12).

8. Unité modulaire selon la revendication 7,
**caractérisée en ce que**
l'élément de fixation (20) peut être guidé à travers une ouverture de passage (72) prévue au niveau de la carte à circuits imprimés (14, 16, 18) et peut être fixé au moyen d'un élément de retenue (76, 86) prévu sur l'élément de fixation (20) par un mouvement de rotation de l'élément de fixation (20) sur une surface de l'au moins une carte à circuits imprimés (14, 16, 18).

9. Unité modulaire selon l'une quelconque des revendications 1 à 8,
**caractérisée en ce**
**qu'**au moins l'un des deux éléments latéraux (26) présente une ouverture (28).

10. Unité modulaire selon l'une quelconque des revendications 1 à 9,
**caractérisée en ce que** l'unité modulaire présente un ou plusieurs éléments de contact de potentiel de terre (36).

11. Unité modulaire selon l'une quelconque des revendications 1 à 10,
**caractérisée en ce que** l'unité modulaire présente un élément de base (32, 34) pour la fixation de l'élément de réception (12) et/ou d'un élément latéral (26) à un rail porteur (10).

12. Procédé de fabrication d'une unité modulaire selon l'une quelconque des revendications 1 à 11, dans lequel des éléments de réception (12) d'un profilé extrudé sont découpés à la longueur souhaitée, des évidements (44) étant simultanément réalisés dans les éléments de réception lors de la découpe à la longueur souhaitée.

13. Procédé selon la revendication 12, **caractérisé en ce que** pour la découpe à la longueur souhaitée et pour la réalisation des évidements (44), on utilise un dispositif de sciage, des éléments de réception (12) du profilé extrudé étant découpés à la longueur souhaitée par le biais d'une lame de scie principale du dispositif de sciage et, par le biais de deux lames de scie supplémentaires prévues sur le dispositif de sciage, un évidement étant à chaque fois réalisé à un bout de l'élément de réception (12) devant être découpé à la longueur souhaitée et au niveau d'un début d'un élément de réception suivant devant être découpé à la longueur souhaitée.
